(19) Europäisches Patentamt
European Patent Office
Office européen des brevets

(11) **EP 2 156 198 B1**

(12) **EUROPÄISCHE PATENTSCHRIFT**

(45) Veröffentlichungstag und Bekanntmachung des Hinweises auf die Patenterteilung:
**03.08.2011 Patentblatt 2011/31**

(21) Anmeldenummer: **08716551.0**

(22) Anmeldetag: **14.03.2008**

(51) Int Cl.:
*G01P 15/18* (2006.01)   *H03K 17/975* (2006.01)

(86) Internationale Anmeldenummer:
**PCT/EP2008/002059**

(87) Internationale Veröffentlichungsnummer:
**WO 2008/151683 (18.12.2008 Gazette 2008/51)**

(54) **BETRIEBSVERFAHREN UND SCHALTUNGSANORDNUNG FÜR EINEN KAPAZITIVEN MIKROMECHANISCHEN SENSOR MIT ANALOGER RÜCKSTELLUNG**

OPERATION METHOD AND SWITCH ARRANGEMENT FOR A CAPACITIVE MICROMECHANICAL SENSOR WITH ANALOG RESET

PROCÉDÉ ET CIRCUIT POUR FAIRE FONCTIONNER UN CAPTEUR MICROMÉCANIQUE CAPACITIF À RAPPEL ANALOGIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **15.06.2007 DE 102007027652**

(43) Veröffentlichungstag der Anmeldung:
**24.02.2010 Patentblatt 2010/08**

(73) Patentinhaber: **Northrop Grumman LITEF GmbH 79115 Freiburg (DE)**

(72) Erfinder: **SPAHLINGER, Günter 70188 Stuttgart (DE)**

(74) Vertreter: **Zinke, Thomas
Müller Hoffmann & Partner
Patentanwälte
Innere Wiener Straße 17
81667 München (DE)**

(56) Entgegenhaltungen:
**DE-A1- 19 959 128        DE-A1-102004 039 924
DE-A1-102005 044 383**

**Beschreibung**

Erfindungsgegenstand ist ein Betriebsverfahren für einen kapazitiven mikromechanischen Sensor, der mindestens einen durch zwei feststehende Elektroden und eine dazwischen angeordnete, federnd aufgehängte, durch eine externe Kraft auslenkbare bewegliche Mittelelektrode gebildeten Differenzialkondensator aufweist, deren Auslenkung gemessen wird, wobei zwischen den feststehenden Elektroden und der Mittelelektrode entgegengesetzte Erregerspannungen angelegt werden. Die Erfindung bezieht sich außerdem auf eine Schaltungsanordnung zum Betreiben eines mikromechanischen Sensors der erwähnten Art.

Unter dem Begriff mikromechanische Sensoren, auch MEMS-Sensoren genannt, werden mikromechanische Beschleunigungsmesser, mikromechanische Drehratensensoren sowie mikromechanische Sensoren mit Kammantrieben verstanden.

Der Sensor besteht in seiner Grundvariante aus einem Differenzialkondensator, dessen Mittelelektrode federnd aufgehängt ist und die demzufolge mit einer Auslenkung auf Kräfte reagiert, die auf sie einwirken. Die Auslenkung wird durch entsprechende grundsätzlich bekannte schaltungstechnische Maßnahmen gemessen. Bei einem rückstellenden System (Closed-Loop-Anordnung) wird der Messwert einem Regler zugeführt, der die elektrostatischen Kräfte, die auf die Platten des Differenzialkondensators wirken, in dem Sinne beeinflusst, dass es zu einer Kompensation der externen Beschleunigungskraft kommt. Dieser Vorgang wird als Rückstellung bezeichnet. Die Rückstellung ist perfekt, wenn die Auslenkung der Mittelelektrode "O" wird.

Die Erfindung ist darauf gerichtet, die Genauigkeit solcher MEMS-Sensoren deutlich zu verbessern.

Der Erfindung liegt zunächst die Erkenntnis zugrunde, dass sich die jeweils auf die Auslenkung der Mittelelektrode des Differenzialkondensators wirkende Kraft einerseits aus einer (externen) Beschleunigungskraft sowie aus einer (inneren) elektrostatischen Kraft (Rückstellkraft) zusammensetzt.

Ausgehend von dieser Erkenntnis besteht die Erfindung einerseits bei einem Betriebsverfahren für einen kapazitiven mikromechanischen Sensor der eingangs genannten Gattung darin, dass ein der elektrostatischen Rückstellkraft entsprechender, als "Rückstell-Durchsprechen" bezeichneter dem Auslesesignal (Messwert) überlagerter Anteil, kompensiert wird.

Bezogen auf eine Anordnung zum Betreiben eines mikromechanischen Sensors, der im Wesentlichen durch mindestens einen Differenzialkondensator mit zwei feststehenden Elektroden und einer zwischen diesen federnd beweglich aufgehängten Mittelelektroden gebildet ist, die durch eine externe Kraft auslenkbar ist, mit Mitteln zur Beaufschlagung der beiden feststehenden Elektroden mit einer jeweils gegenpoligen Erregerspannung und mit Mitteln um die Auslenkung der Mittelelektrode bei einer Krafteinwirkung als Messwert auszugeben, ist die Erfindung andererseits gekennzeichnet durch eine Einrichtung zur Kompensation der als "Rückstell-Durchsprechen" bezeichneten Verfälschung des Messwertes (Auslesesignals).

Bei einer bevorzugten Ausführungsform des Betriebsverfahrens wird zum Ausgangssignal einer Grundanordnung des mikromechanischen Sensors ein dem Rückstell-Durchsprechen entsprechendes Signal addiert und das Additionsergebnis wird als die Auslenkung der Mittelelektrode angebendes Auslesesignal bereitgestellt. Bei zu bevorzugendem Closed-Loop-Betrieb des Sensors beeinflusst das Auslesesignal über einen Regler das Rückstell-Durchsprechsignal ergänzend derart, dass die dadurch entstehende Kapazität der Rückstellkraft einer Auslenkung der Mittelelektrode kompensierend entgegenwirkt.

Um ein Driften des Auslesesignals der Sensoranordnung zu verhindern, ist es vorteilhaft, die Erregerspannung, welche die feststehenden Elektroden beaufschlagt, nach einem deterministischen oder stochastischem Umpolverfahren laufend umzupolen.

Eine erfindungsgemäße Schaltungsanordnung zum Betreiben eines mikromechanischen Sensors der eingangs genannten Gattung ist erfindungsgemäß gekennzeichnet durch eine Einrichtung zur Kompensation der als Rückstell-Durchsprechen bezeichneten Verfälschung des Messwertes. Der Messwert des Sensors wird beispielsweise und insbesondere als Spannungswert ausgegeben, wobei es vorteilhaft ist, eine Summation vorzusehen, durch die ein dem Rückstell-Durchsprechen entsprechender Rückstell-Spannungswert zu einem von der Grundanordnung des Sensors gelieferten Ausgangsspannungswert addiert wird. In diesem Fall kann ein Regler vorgesehen werden, dessen Eingang durch ein vom Rückstell-Durchsprechen befreites Auslesesignal beaufschlagt ist und der bei einer Auslenkung der Mittelelektrode den Spannungswert der Rückstellung so nachstellt, dass eine dadurch generierte kapazitive Rückstellkraft der Auslenkung der Mittelelektrode entgegenwirkt.

Der Regler kann ein Proportional-Regler (P-Regler) oder ein Proportional-Integral-Regler (PI-Regler) jeweils mit frequenzabhängiger Verstärkung sein. Im Falle eines PI-Reglers ist dieser vorteilhafterweise durch einen Operationsverstärker mit einem durch die Serienschaltung eines ohmschen Widerstand und einer Kapazität gebildeten komplexen Rückkopplungszweig gebildet. Sofern vorgesehen ist, das Driften des Auslesesignals durch das erwähnte deterministische oder stochastische Umpolen der Erregerspannung an den feststehenden Elektroden des Differenzialkondensators zu verhindern, sollte auch die Kapazität im komplexen Rückkopplungswiderstand des PI-Reglers entsprechend umpolbar sein.

Nachfolgend wird die Erfindung, insbesondere anhand mehrerer Ausführungsbeispiele weiter erläutert. Es zeigen:

**Fig.1** eine erste Grundschaltung eines kapazitiven MEMS-Sensors mit Differenzialkondensator, bei der ein Referenzkondensator C durch zwei parallel geschaltete variable Kapazitäten gemäß **Fig. 1a** gebildet sein kann;

**Fig. 2** eine Variante der Grundschaltung nach Figur 1 für den Betrieb eines MEMS-Sensors mit Differenzialkondensator;

**Fig.3** ein Prinzip-Blockschaltbild zur Verdeutlichung der Kompensation des so genannten Rückstell-Durchsprechens gemäß der Erfindung;

**Fig.4** eine erste Ausführungsvariante für die Kompensation des Rückstell-Durchsprechens, veranschaulicht anhand der Grundschaltung der Figur 1 bei Realisierung der Anordnung nach Figur 3;

**Fig. 5** eine mögliche Realisation der Kompensation des Rückstell-Durchsprechens nach Figur 3 unter Verwendung der Sensor-Grundschaltung nach Figur 2;

**Fig. 6** ein Prinzip-Schaltungsbeispiel für einen invertierenden Regler wie er für die gestrichelt in Figur 3 dargestellte Ausführungsvariante eines in Closed-Loop betriebenen Sensors verwendet werden kann;

**Fig. 7** das schaltungstechnische Grundprinzip für einen nicht-invertierenden Regler;

**Fig. 8** eine mögliche, zu bevorzugende Impedanz im Rückkopplungszweig bei Verwendung eines PI-Reglers bei einer Closed-Loop-Anordnung des MEMS-Sensors;

**Fig. 9** die der Figur 8 entsprechende Impedanz für einen PI-Regler jedoch mit umpolbarem Kondensator bei deterministischer oder stochastischer Umpolung der Erregerspannung am Differenzialkondensator;

**Fig. 10** ein erstes Ausführungsbeispiel für eine Kombination von Regelung und Kompensation bei einer Closed-Loop-Anordnung für einen MEMS-Sensor mit erfindungsgemäßen Merkmalen;

**Fig. 11** eine zweite Schaltungsanordnungsvariante die der zusammengefassten Regelung und Kompensation der Schaltung nach Figur 10 entspricht, jedoch unter Verwendung der Grundschaltung nach Figur 2; und

**Fig. 12** eine komplette Schaltungsanordnung für einen rückstellenden MEMS-Sensor mit PI-Regler und deterministischer/stochastischer Umpolung der Erregerspannung und des Kondensators im komplexen Rückkopplungswiderstand eines PI-Reglers.

Einander entsprechende Baugruppen oder funktionsmäßig einander entsprechende Teile sind in allen Figuren mit den gleichen Bezugshinweisen gekennzeichnet.

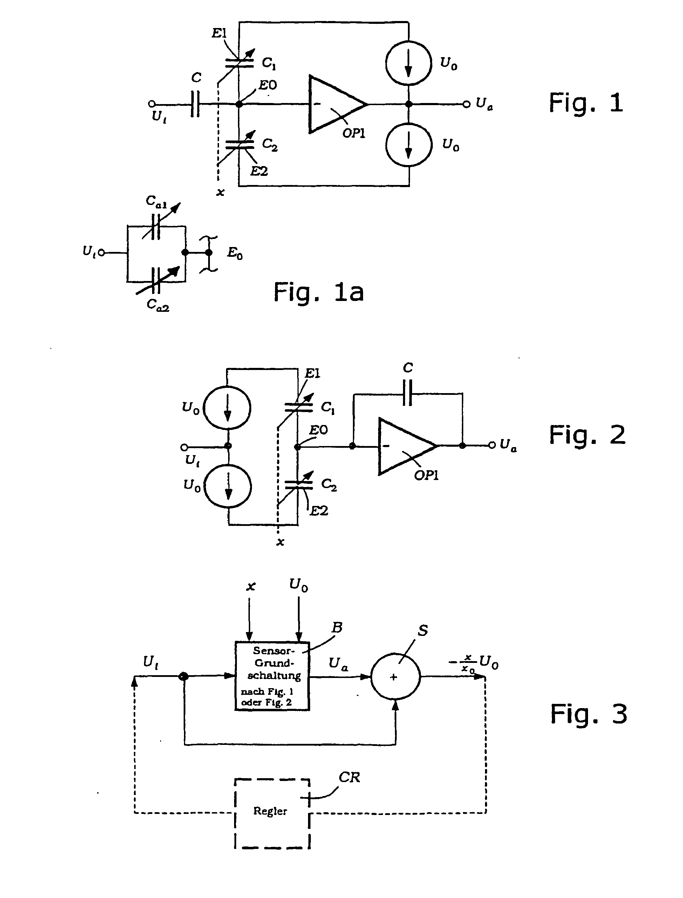

Anhand der Figuren 1 und 2 werden zwei Grundschaltungen angegeben, welche die Auslesefunktion für die Auslenkung x einer beweglichen Mittelelektrode E0 eines MEMS-Sensors bereitstellen, und die es erlauben, eine vorgegebene Rückstellkraft auf die bewegliche Mittelelektrode E0 aufzuprägen. Nachfolgend werden Konzepte für einen kompletten Closed-Loop-Regelkreis aufgezeigt.

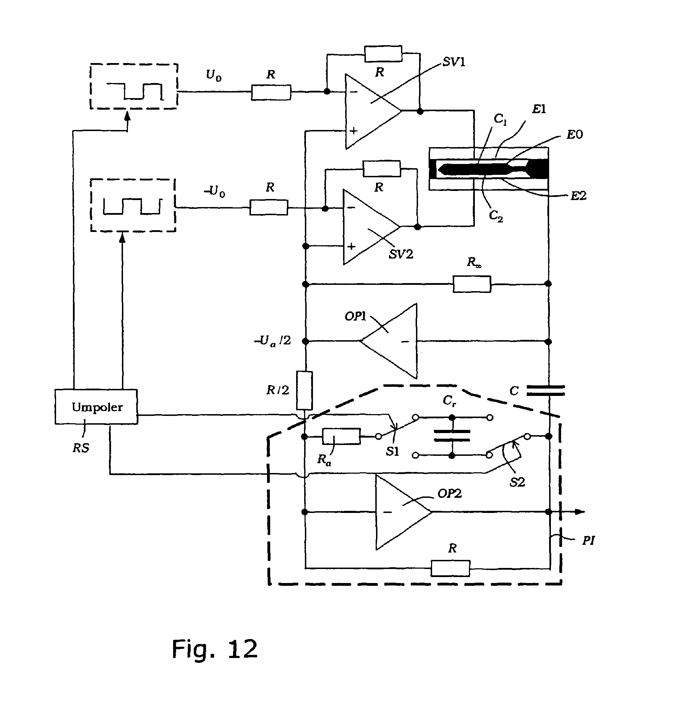

Fig. 1 verdeutlicht eine erste Grundschaltung eines kapazitiven MEMS-Sensors mit hermetisch gekapseltem Differenzialkondensator (vergl. Fig. 12). Der durch die Kapazitäten $C_1$ und $C_2$ zwischen feststehenden Elektroden E1 und E2 und einer federnd aufgehängten Mittelelektrode E0 gebildete Differenzialkondensator ist von einer Auslenkung x der federnd aufgehängten Mittelelektrode E0 abhängig, wobei die linearisierte Abhängigkeit durch

$$C_1 = \frac{C_0}{2}\left(1 + \frac{x}{x_0}\right) \qquad\qquad (1a)$$

$$C_2 = \frac{C_0}{2}\left(1 - \frac{x}{x_0}\right) \qquad\qquad (1b)$$

wiedergegeben wird.

Die feststehenden Elektroden E1 und E2 sind - entgegengesetzt gepolt - mit der gleichen Erregerspannung $U_o$ gegen den Ausgang eines Operationsverstärkers OP1 beaufschlagt, an dessen Eingang die Mittelelektrode E0 angebunden ist. Der Ausgang des Operationsverstärkers OP1 liefert einen Ausgangsspannungswert $U_a$. Die Mittelelektrode E0 ist außerdem über einen Referenzkondensator C durch eine Spannung $U_1$ beaufschlagt. deren Bedeutung weiter unten erläutert wird. Um einen von der Auslenkung der Mittelelektrode E0, der Temperatur und Alterung unabhängigen Brückenabgleich zu erreichen ist es von besonderem Vorteil den Referenzkondensator C durch die Parallelschaltung zweier variabler Kapazitäten $C_{a1}(x)$ und $C_{a2}(x)$ zu bilden (vergl. Fig. 1a), wobei sich die Kapazitätswerte in Abhängigkeit von der Auslenkung x ändern.

$$C(x) = C_{a1}(x) + C_{a2}(x) \qquad\qquad (2)$$

Falls $C_{a1}(x) \sim C_1(x)$ und $C_{a2}(x) \sim C_2(x)$ gewählt wird gilt

$$\frac{C(x)}{C_0(x)} = \frac{C_{a1}(x) + C_{a2}(x)}{C_1(x) + C_2(x)} = konst. \qquad\qquad (2a)$$

und unabhängig von der Auslenkung.

Diese Maßnahme eignet sich für alle MEMS-Sensoren mit Rückstell-Durchsprechen, auch für mikromechanische Coriolis-Kreisel.

Im Folgenden wird die erste Grundschaltung eines MEMS-Sensors mit Differenzialkondensator hinsichtlich ihrer Auslesefunktion und nachfolgend hinsichtlich einer Rückstellfunktion untersucht.

Mit Bezug auf Figur 1 gilt für die Ladungen $Q_1$, $Q_2$ auf dem Differenzialkondensator:

$$Q_1 = C_1(U_a + U_0) \qquad\qquad (3)$$

$$Q_2 = C_2(U_a - U_0) \qquad\qquad (4)$$

Für den Referenzkondensator C ist

$$Q = CU_1 \qquad\qquad (5)$$

Der gemeinsame Schaltungspunkt, also die Mittelelektrode E0 liegt auf virtueller Masse. Für einen idealen Operationsverstärker OP1 muss bei Verschwinden der Anfangsladung das Kirchhoffsche Gesetz

$$Q + Q_1 + Q_2 = 0 \qquad (6)$$

gelten. Aus den Gleichungen (3) bis (6) folgt

$$C_1(U_a + U_0) + C_2(U_a - U_0) = -CU_i \qquad (7)$$

oder mit Gleichungen (1) und (2)

$$\frac{C_0}{2}\left(1 + \frac{x}{x_0}\right)(U_a + U_0) + \frac{C_0}{2}\left(1 - \frac{x}{x_0}\right)(U_a - U_0) = -CU_i \qquad (8)$$

$$\left(1 + \frac{x}{x_0}\right)(U_a + U_o) + \left(1 - \frac{x}{x_0}\right)(U_a - U_0) = -U_i\frac{2C}{C_0} \qquad (9)$$

$$U_a + \frac{x}{x_0}U_0 = -U_i\frac{C}{C_0} \qquad (10)$$

$$U_a = -\frac{x}{x_0}U_0 - U_i\frac{C}{C_0} \qquad (11)$$

In den Gleichungen (1) bis (11) sind mit $x_o$ der Bezugspunkt für die Auslenkung x und mit $C_o$ die Summe der beiden Teilkapazitäten $C_1$. $C_2$ in Ruhelage des Differenzialkondensators (x = o) bezeichnet. Der Term $U_a$ für die Ausgabespannung der Sensorgrundanordnung setzt sich aus zwei Teilen zusammen wie die Gleichung (11) erkennen lässt. Der erste Teil ist die von der Auslenkung x abhängige Auslesefunktion. Der zweite Teil ist von $U_i$ abhängig, wobei $U_i$ ein Maß für die innere elektrostatische Kraft (Rückstellkraft) angibt, wie im nächsten Abschnitt gezeigt und zur Rückstellung des Sensors verwendet wird. Dieser zweite (unerwünschte Teil) wird hier und in der folgenden Beschreibung als Rückstell-Durchsprechen bezeichnet.

Nachfolgend wird die Rückstellfunktion näher erläutert:

Für die Spannungen am Differenzialkondensator gilt für den Teilkondensator $C_1$:

$$U_1 = U_a + U_0 \qquad (12)$$

und für den Teilkondensator $C_2$:

$$U_2 = U_a - U_0 \qquad (13)$$

Die elektrostatischen Kräfte, die in Summe auf die bewegliche Elektrode E0 des Differenzialkondensators wirken, ergeben sich wie folgt:

$$F = \frac{U^2_1}{2}\frac{dC_1}{dx} + \frac{U_2^2}{2}\frac{dC_2}{dx} \qquad (14)$$

$$= \left(U^2_1 - U^2_2\right)\frac{1}{4}\frac{C_0}{x_0} \qquad (15)$$

$$= (U_1 - U_2)(U_1 + U_2)\frac{1}{4}\frac{C_0}{x_0} \qquad (16)$$

$$F = U_0 U_a \frac{C_0}{x_0} \qquad (17)$$

$$F = -U_0 U_i \frac{C}{x_0} - U_0^2 \frac{x C_0}{x^2_0} \qquad (18)$$

Diese elektrostatische Kraft F setzt sich aus einem von $U_i$ abhängigen Teil, der inneren elektrostatischen Kraft, und aus einem (unerwünschten), von der Auslenkung x abhängigen, der externen Beschleunigungskraft entsprechenden Teil zusammen, der durch eine negative Federkonstante bestimmt ist.

Fig. 2 veranschaulicht eine zweite Grundschaltungsvariante für den Betrieb eines MEMS-Sensors mit Differenzialkondensator. Der Referenzkondensator C liegt jetzt als direkter Rückkopplungszweig parallel zum Operationsverstärker OP 1. Bei einer mathematischen Analyse ergibt sich, dass gegenüber der Grundschaltung nach Fig. 1 im Wesentlichen die Spannungen $U_i$ und $U_a$ die Rollen getauscht haben.

Für die Auslesefunktion gilt:

$$U_a = -\frac{x}{x_0} U_0 \frac{C_0}{C} - U_i \frac{C_0}{C} \qquad (19)$$

Auch hier kennzeichnet der erste Term der Auslesespannung $U_a$ der Sensorgrundanordnung die von der Auslenkung x abhängige Auslesefunktion und der zweite Term das Rückstell-Durchsprechen.

Für die Rückstellfunktion des sich auf die innere elektrostatische Kraft beziehenden Teils gilt (analog zu Gleichung (17)):

$$F = U_0 U_i \frac{C_0}{x_0} \qquad\qquad (20)$$

Im Folgenden wird die Kompensation des Rückstell-Durchsprechens gemäß der Erfindung genauer beschrieben.

Wie aus den Gleichungen (11) und (19) ersichtlich, stellen die beiden Schaltungsvarianten nach den Figuren 1 und 2 an ihrem Ausgang eine Auslesespannung $U_a$ zur Verfügung, die neben einem von der Auslenkung x bestimmten Anteil auch den als Rückstell-Durchsprechen bezeichneten und von $U_i$ abhängigen Anteil enthält. Wenn die MEMS-Sensoren im Closed-Loop-Betrieb zufriedenstellend arbeiten sollen, ist dieses Durchsprechen zu kompensieren. Ohne Beschränkung der Allgemeinheit sei $C = C_0$. Dann ergibt sich in beiden Fällen aus den Gleichungen (11) bzw. (19):

$$U_a = -\frac{x}{x_0} U_0 - U_i \qquad\qquad (21)$$

Betrachtet man nun das Prinzip-Blockschaltbild der Figur 3 mit der Sensorgrundschaltung B nach Figur 1 oder Figur 2 mit den Eingangsgrößen Auslenkung x und Erregerspannung $U_0$, so erhält man ein von $U_i$ befreites Auslesesignal der Größe $-\frac{x}{x_0} U_0$, wenn man zum Ausgangssignal $U_a$ der Sensor-Grundschaltung die Rückstellspannung $U_i$ an einem Summationspunkt S addiert. Führt man nun zusätzlich das Auslesesignal $-\frac{x}{x_0} U_0$ einem Regler CR zu, so ergibt sich das Prinzip eines Closed-Loop-Betriebs wie in Figur 3 durch gestrichelte Ergänzung eingezeichnet.

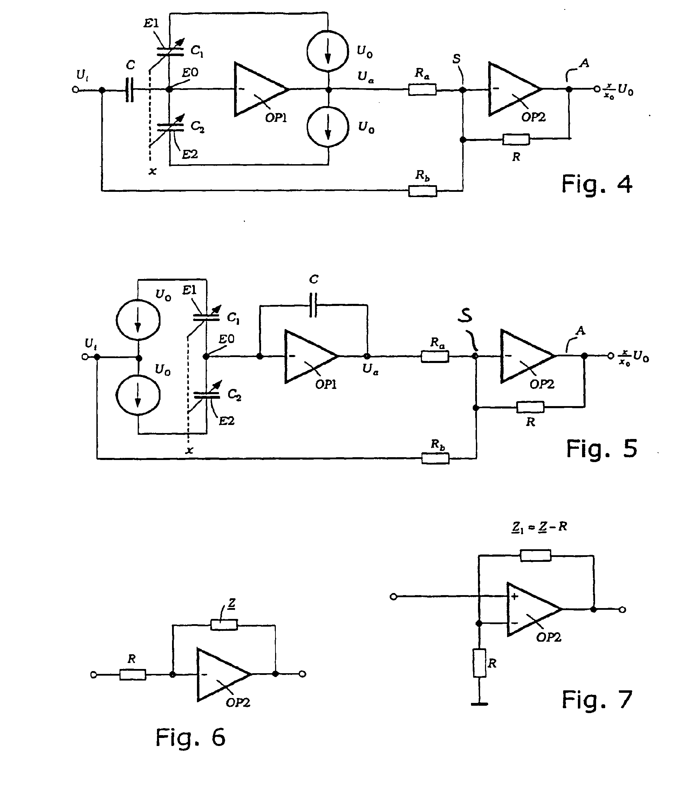

In den Schaltungsbeispielen der Figuren 4 und 5 ist gezeigt, wie sich die Kompensation des Rückstell-Durchsprechens für die Schaltung nach Figur 1 bzw. die Schaltung nach Figur 2 realisieren lässt. Die bereits anhand der Figuren 1 und 2 erläuterten Bauteile und Funktionen werden nicht erneut beschrieben. Die Addition der Rückstellspannung $U_i$ erfolgt am Summationspunkt S. Über einen entkoppelnden Operationsverstärker OP2 erhält man am Ausgang A das vorzeichen-richtige Auslesesignal $U_x = \frac{x}{x_0} U_0$.

Bei einem Closed-Loop-Betrieb muss der Regler im richtigen Sinn wirken. d. h. bei einer entstehenden Auslenkung x muss $U_i$ so nachgestellt werden, dass die entstehende Rückstellkraft der Auslenkung entgegenwirkt. Dies bedeutet konkret, dass die Schaltung nach Figur 4 einen nicht-invertierenden Regler und die Schaltung nach Figur 5 einen invertierenden Regler benötigt.

Werden der Referenzkondensator C, der durch die Teilkapazitäten $C_1$, $C_2$ gebildete Differenzialkondensator $C_0$ sowie die individuellen Widerstände $R_a$, $R_b$ in derselben Technik realisiert, so lässt sich die Abgleichbedingung $C/C_0 = R_a/R_b$ über Zeit und bei Temperaturschwankungen gut einhalten.

Eine Realisierung für den Regler bei Closed-Loop-Betrieb wird nachfolgend beschrieben:

Der Regler muss dafür sorgen, dass einer auftretenden Auslenkung x entgegengewirkt wird. Dieser Regler besteht im Wesentlichen aus einem Verstärker mit der möglicherweise frequenzunbhängigen Verstärkung $\alpha$. Der Regler kann dann beispielsweise als Proportional-Regler (P Regler) mit frequenzabhängiger Verstärkung $\alpha$ oder als Proportional-Integral-Regler (PI Regler) ebenfalls mit frequenzabhängiger Verstärkung ($\alpha = \beta + 1/j\omega\gamma$) ausgeführt werden. Darüber hinaus muss der Regler das korrekte Vorzeichen der Verstärkung bereitstellen. Das heißt, man muss zwischen einem invertierenden Regler (Fig. 6) und einem nicht-invertierenden Regler (Fig. 7) unterscheiden. Die Verstärkung des Operationsverstärkers OP2 ergibt sich aus

$$\alpha = \pm \frac{Z}{R} \qquad\qquad (22)$$

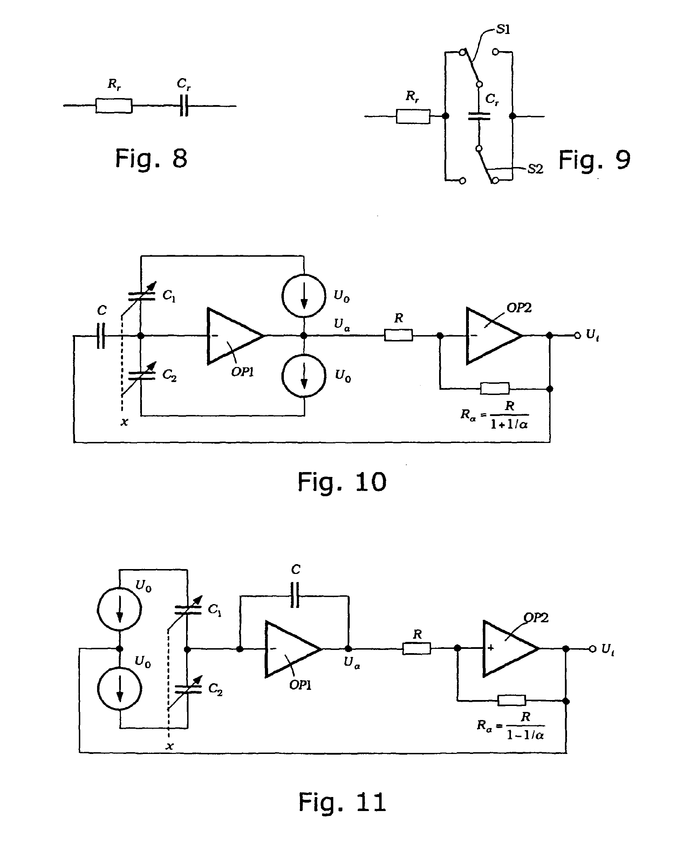

wobei das negative Vorzeichen (-) für den Regler in Figur 6 und das positive Vorzeichen (+) für den Regler nach Figur 7 gilt. $\underline{Z}$ beschreibt eine im Allgemeinen frequenzabhängige (komplexe) Impedanz. Mit $\underline{Z}$ kann die Reglercharakteristik eingestellt werden. Für einen Proportional-Regler (nach Fig. 6) verwendet man für $\underline{Z}$ einen ohmschen Widerstand, während bei einem Proportional-Integral-Regler insbesondere eine Serienschaltung aus einem ohmschen Widerstand $R_r$ mit einem Kondensator $C_r$ (vergl. Fig. 8) vorzusehen ist.

Es sei erwähnt, dass die Biasströme des in den Figuren linken Operationsverstärkers OP1 zum Wegdriften des Nullpunkts führen können. Dem kann gemäß einer vorteilhaften Ergänzung der Erfindung begegnet werden, indem man die Erregerspannung $U_o$ beispielsweise in regelmäßigen Abständen umpolt und einen sehr großen Widerstand $R_\infty$ vom Ausgang des Operationsverstärkers OP1 auf dessen invertierenden Eingang führt. Wie oben dargestellt, geht das Vorzeichen von $U_o$ sowohl in den Auslesefaktor als auch in das Vorzeichen der Kraft ein, sodass das Vorzeichen des Reglers unverändert bleibt. Das Umpolen von $U_o$ kann entweder periodisch oder nach einer Zufalls- oder Pseudo-Zufalls-Funktion erfolgen. Der Biasstrom für den Operationsverstärker OP1 mittelt sich dann heraus.

Für den Fall, dass $U_o$ aus den genannten Gründen nach einer bestimmten Funktion umgepolt wird, muss auch der Kondensator $C_r$ der Impedanz des PI Reglers gemäß der selben Funktion umgepolt werden, was zu der Schaltung nach Figur 9 führt.

Nachfolgend wird für eine besonders vorteilhafte Ausführungsvariante der Erfindung die Zusammenfassung der Kompensation des Rückstell-Durchsprechens und der Regelung bei Closed-Loop-Betrieb des MEMS Sensors beschrieben.

Die Funktionen der Kompensation des Rückstell-Durchsprechens und der Regelung lassen sich vorteilhaft zusammenfassen. Fig. 10 zeigt die sich dabei für die erste Schaltungsvariante nach Fig. 1 ergebende Schaltungsstruktur. Dabei wird mit einem Widerstand

$$R_\alpha = \frac{R}{1 + 1/\alpha} < R \qquad\qquad (23)$$

die Verstärkung $\propto$ des Reglers eingestellt; für $R_\alpha = R$ wird sie unendlich. Zu beachten ist, dass die angegebenen Verhältnisse nur für $C = C_o$ gelten. Wird diese Bedingung nicht erfüllt, so muss $R_\alpha$ entsprechend skaliert werden.

Ganz analog ergibt sich für die zweite Grundschaltung nach Figur 2 die Schaltungsstruktur der Figur 11. Hier wird die Verstärkung $\alpha$ des Reglers mit

$$R_\alpha = \frac{R}{1 - 1/\alpha} > R \qquad\qquad (24)$$

eingestellt; für $R_\alpha = R$ wird sie unendlich.

Es sei erwähnt, dass für beide Schaltungen nach den Figuren 10 und 11 eine Abgleichbedingung einzuhalten ist, die bei der zulässigen Toleranz für die verwendeten Bauteile zu berücksichtigen ist.

Die Figur 12 veranschaulicht eine komplette Schaltung als Ausführungsbeispiel für einen rückstellenden Closed-Loop-MEMS-Sensor mit erfindungsgemäßen Merkmalen. Dieses Ausführungsbeispiel basiert auf der ersten Variante der Grundschaltung nach Figur 1 und besitzt einen PI Regler mit einem komplexen Rückkopplungswiderstand gemäß Figur 9. Die aus oben genannten Gründen durch einen periodisch oder nach einer Pseudo-Zufallsfunktion gesteuerten Umpoler RS bereitgestellte Erregerspannung $U_o$ wird hier nicht durch potenzialfreie Spannungsquellen eingebracht, sondern über eigene Summierverstärker SV1 bzw. SV2. Diese Summierverstärker SV1, SV2 befinden sich in der Regelschleife und haben für diese eine Verstärkung von "2". Diese zusätzliche Verstärkung ist durch entsprechende Dimensionierungsmaßnahmen an anderer Stelle der Schaltung berücksichtigt. Der Umpoler RS betätigt gleichzeitig Schalter S1. S2 zur Umpolung des Kondensators $C_r$ der Impedanz $\underline{Z}$ des PI-Reglers.

**Patentansprüche**

1. Betriebsverfahren für einen kapazitiven mikromechanischen Sensor, der mindestens einen durch zwei feststehende Elektroden (E1. E2) und eine dazwischen angeordnete, federnd aufgehängte, durch eine externe Kraft auslenkbare bewegliche Mittelelektrode (E0) gebildeten Differenzialkondensator aufweist, wobei zwischen den feststehenden Elektroden und der Mittelelektrode entgegengesetzte Erregerspannung ($U_o$) angelegt und die Auslenkung der Mittelelektrode gemessen wird, **dadurch gekennzeichnet, dass** ein der elektrostatischen Rückstellkraft entsprechender, als Rückstell-Durchsprechen bezeichneter Anteil der an der Mittelelektrode abgreifbaren Ladung kompensiert wird.

2. Betriebsverfahren nach Anspruch 1, **dadurch gekennzeichnet, dass** zum Ausgangssignal ($U_a$) der Grundanordnung des kapazitiven mikromechanischen Sensors ein dem Rückstell-Durchsprechen ($U_i$) entsprechendes Signal addiert und das Additionsergebnis als die Auslenkung der Mittelelektrode angebendes Auslesesignal bereitgestellt wird.

3. Betriebsverfahren nach Anspruch 2, **dadurch gekennzeichnet, dass** bei Closed-Loop-Betrieb des Sensors das Auslesesignal über einen Regler (CR) das Rückstell-Durchsprech Signal ergänzend so beeinflusst, dass die **dadurch** entstehende kapazitive Rückstellkraft einer Auslenkung der Mittelelektrode kompensierend entgegenwirkt.

4. Betriebsverfahren nach Anspruch 2, **dadurch gekennzeichnet, dass** ein Driften des Nullpunkts des Sensors durch ein deterministisches Umpolen der Erregerspannung ($\pm U_o$) verhindert wird.

5. Betriebsverfahren nach Anspruch 2, **dadurch gekennzeichnet, dass** ein Driften des Nullpunkts des Sensors durch ein stochastisches Umpolen der Erregerspannung ($\pm U_o$) verhindert wird.

6. Betriebsverfahren nach Anspruch 3, **dadurch gekennzeichnet, dass** ein PI-Regler zur Generierung der kapazitiven Rückstellkraft verwendet wird.

7. Schaltungsanordnung zum Betreiben eines mikromechanischen Sensors der mindestens einen Differenzialkondensator, gebildet durch zwei feststehende Elektroden (E1, E2) und eine zwischen diesen federnd beweglich aufgehängte Mittelelektrode (E0), die durch eine externe Kraft auslenkbar ist, mit Mitteln zur Beaufschlagung der beiden feststehenden Elektroden mit einer jeweils gegenpoligen Erregerspannung ($\pm U_o$) und mit Mitteln um die Auslenkung der Mittelelektrode bei einer Krafteinwirkung als Messwert auszugeben, **gekennzeichnet durch** eine Einrichtung zur Kompensation der als Rückstell-Durchsprechen bezeichneten elektrostatischen Rückstellkraft an der Mittelelektrode.

8. Schaltungsanordnung nach Anspruch 7, bei der der Messwert als Spannungswert ausgegeben wird, **gekennzeichnet durch** eine Einrichtung (S) zur Summation eines dem Rückstell-Durchsprechen entsprechenden Rückstell-Spannungswerts ($U_i$) zu einem von einer Grundanordnung des Sensors gelieferten Ausgangsspannungswert ($U_a$).

9. Schaltungsanordnung nach Anspruch 8, mit einem Regler, dessen Eingang durch ein vom Rückstell-Durchsprechen befreites Auslesesignal beaufschlagt ist und der bei einer Auslenkung der Mittelelektrode den Spannungswert der Rückstellung so nachstellt, dass eine **dadurch** generierte kapazitive Rückstellkraft der Auslenkung der Mittenelektrode entgegenwirkt.

10. Schaltungsanordnung nach Anspruch 9, **gekennzeichnet durch** eine deterministisch oder stochastisch gesteuerte Umpoleinrichtung (RS) für die Erregerspannung ($\pm U_o$).

11. Schaltungsanordnung nach Anspruch 10, **dadurch gekennzeichnet, dass** der Regler ein P-Regler mit frequenzunabhängiger Verstärkung ist.

12. Schaltungsanordnung nach Anspruch 10, **dadurch gekennzeichnet, dass** der Regler ein PI-Regler mit frequenzabhängiger Verstärkung ist.

13. Schaltungsanordnung nach Anspruch 12, **dadurch gekennzeichnet, dass** der PI-Regler durch einen Operationsverstärker (OP2) mit einem durch die Serienschaltung eines ohmschen Widerstands ($R_r$) und einer Kapazität ($C_r$) gebildeten komplexen Rückkopplungszweigs gebildet ist.

14. Schaltungsanordnung nach Anspruch 10, **dadurch gekennzeichnet, dass** der Regler ein PI-Regler mit frequenzabhängiger Verstärker ist, gebildet durch einen Operationsverstärker mit einer Serienschaltung eines ohmschen Widerstands ($R_r$) und einer durch einen Umpolschalter (S 1, S2) umpolbaren Kapazität ($C_r$), wobei der Umpolschalter durch die Umpoleinrichtung (RS) für die Erregerspannung ($\pm U_o$) betätigbar ist.

**Claims**

1. An operating method for a capacitive micromechanical sensor having at least one differential capacitor which is formed by two stationary electrodes (E1, E2) and a movable center electrode (E0) which is arranged between the latter, is suspended in a resilient manner and can be deflected by an external force, wherein an opposite excitation voltage ($U_o$) being applied between the stationary electrodes and the center electrode and the deflection of the center electrode being measured, **characterized in that** a proportion of the charge which can be tapped off at the center electrode is compensated for, which proportion corresponds to the electrostatic restoring force and is referred to as the reset crosstalk.

2. The operating method as claimed in claim 1, **characterized in that** a signal corresponding to the reset crosstalk ($U_i$) is added to the output signal ($U_a$) from the basic arrangement of the capacitive micromechanical sensor and the result of the addition is provided in the form of a read-out signal which indicates the deflection of the center electrode.

3. The operating method as claimed in claim 2, **characterized in that**, during closed-loop operation of the sensor, the read-out signal additionally influences the reset crosstalk signal via a controller (CR) in such a manner that the resultant capacitive restoring force counteracts a deflection of the center electrode in a compensating manner.

4. The operating method as claimed in claim 2, **characterized in that** drifting of the zero point of the sensor is prevented by deterministically reversing the polarity of the excitation voltage ($\pm U_o$).

5. The operating method as claimed in claim 2, **characterized in that** drifting of the zero point of the sensor is prevented by stochastically reversing the polarity of the excitation voltage ($\pm U_o$).

6. The operating method as claimed in claim 3, **characterized in that** a PI controller is used to generate the capacitive restoring force.

7. A circuit arrangement for operating a micromechanical sensor having at least one differential capacitor formed by two stationary electrodes (E1, E2) and a center electrode (E0) which is movably suspended in a resilient manner between the latter and can be deflected by an external force, said arrangement having means for applying a respective excitation voltage ($\pm U_o$) of opposite polarity to the two stationary electrodes and having means for outputting the deflection of the center electrode during the action of a force in the form of a measured value, **characterized by** a device for compensating for the electrostatic restoring force, which is referred to as the reset crosstalk, at the center electrode.

8. The circuit arrangement as claimed in claim 7, in which the measured value is output in the form of a voltage value, **characterized by** a device (S) for summing a reset voltage value ($U_i$) corresponding to the reset crosstalk and an output voltage value ($U_a$) provided by a basic arrangement of the sensor.

9. The circuit arrangement as claimed in claim 8, having a controller, a read-out signal which has been freed from reset crosstalk being applied to the input of said controller and said controller adjusting the reset voltage value in the case of deflection of the center electrode in such a manner that a capacitive restoring force generated thereby counteracts the deflection of the center electrode.

10. The circuit arrangement as claimed in claim 9, **characterized by** a deterministically or stochastically controlled polarity reversal device (RS) for the excitation voltage ($\pm U_o$).

11. The circuit arrangement as claimed in claim 10, **characterized in that** the controller is a P controller with a frequency-independent gain.

**12.** The circuit arrangement as claimed in claim 10, **characterized in that** the controller is a PI controller with a frequency-dependent gain.

**13.** The circuit arrangement as claimed in claim 12, **characterized in that** the PI controller is formed by an operational amplifier (OP2) having a complex feedback path formed by connecting a nonreactive resistor ($R_r$) and a capacitance ($C_r$) in series.

**14.** The circuit arrangement as claimed in claim 10, **characterized in that** the controller is a PI controller with a frequency-dependent amplifier, formed by an operational amplifier having a series circuit comprising a nonreactive resistor ($R_r$) and a capacitance ($C_r$) whose polarity can be reversed by a polarity reversal switch (S1, S2), the polarity reversal switch being able to be activated by the polarity reversal device (RS) for the excitation voltage ($\pm U_0$).

**Revendications**

**1.** Procédé de fonctionnement pour un capteur micromécanique capacitif qui comporte au moins un condensateur différentiel formé par deux électrodes fixes (E1, E2) et une électrode centrale mobile (EO) disposée entre les deux, à suspension élastique et apte à être déviée par une force externe, étant précisé que des tensions d'excitation ($U_0$) opposées sont appliquées entre les électrodes fixes et l'électrode centrale et que la déviation de l'électrode centrale est mesurée, **caractérisé en ce qu'**une partie, correspondant à la force de rappel électrostatique et appelée réaction directe de rappel, de la charge apte à être prélevée sur l'électrode centrale est compensée.

**2.** Procédé de fonctionnement selon la revendication 1, **caractérisé en ce qu'**un signal correspondant à la réaction directe de rappel ($U_1$) est ajouté au signal de sortie ($U_a$) du dispositif de base du capteur micromécanique capacitif, et le résultat de l'addition est fourni comme signal de sortie indiquant la déviation de l'électrode centrale.

**3.** Procédé de fonctionnement selon la revendication 2, **caractérisé en ce que** lors d'un fonctionnement en boucle fermée du capteur, le signal de sortie influe en complément sur le signal de réaction directe de rappel par l'intermédiaire d'un régulateur (CR) de telle sorte que la force de rappel capacitive ainsi produite agisse à l'encontre d'une déviation de l'électrode centrale et compense cette déviation.

**4.** Procédé de fonctionnement selon la revendication 2, **caractérisé en ce qu'**une dérive du point zéro du capteur est empêchée par une inversion déterministe de la polarité de la tension d'excitation ($\pm U_0$).

**5.** Procédé de fonctionnement selon la revendication 2, **caractérisé en ce qu'**une dérive du point zéro du capteur est empêchée par une inversion stochastique de la polarité de la tension d'excitation ($\pm U_0$).

**6.** Procédé de fonctionnement selon la revendication 3, **caractérisé en ce qu'**un régulateur PI est utilisé pour générer la force de rappel capacitive.

**7.** Circuit pour faire fonctionner un capteur micromécanique qui comporte au moins un condensateur différentiel formé par deux électrodes fixes (E1, E2) et une électrode centrale (EO) qui est montée mobile de manière élastique entre celles-ci et qui est apte à être déviée par une force externe, avec des moyens pour contraindre les deux électrodes fixes à l'aide de tensions d'excitation de pôles opposés ($\pm U_0$), et avec des moyens pour émettre comme valeur de mesure la déviation de l'électrode centrale lorsqu'une force est exercée, **caractérisé par** un dispositif pour compenser la force de rappel électrostatique, appelée réaction directe de rappel, sur l'électrode centrale.

**8.** Circuit selon la revendication 7, avec laquelle la valeur de mesure est émise comme valeur de tension, **caractérisé par** un dispositif (S) pour ajouter une valeur de tension de rappel ($U_1$) correspondant à la réaction directe de rappel, à une valeur de tension de sortie ($U_a$) fournie par un dispositif de base du capteur.

**9.** Circuit selon la revendication 8, avec un régulateur dont l'entrée est sollicitée par un signal de sortie libéré par la réaction directe de rappel et qui, lors d'une déviation de l'électrode centrale, réajuste la valeur de tension du rappel de telle sorte qu'une force de rappel capacitive ainsi générée agisse à l'encontre de la déviation de l'électrode centrale.

**10.** Circuit selon la revendication 9, **caractérisé par** un dispositif d'inversion de polarité (RS) commandé de manière déterministe ou stochastique pour la tension d'excitation ($\pm U_o$).

11. Circuit selon la revendication 10, **caractérisé en ce que** le régulateur est un régulateur P à amplification de la fréquence.

12. Circuit selon la revendication 10, **caractérisé en ce que** le régulateur est un régulateur PI à amplification dépendante de la fréquence.

13. Circuit selon la revendication 12, **caractérisé en ce que** le régulateur PI est formé par un amplificateur opérationnel (OP2) avec une branche de rétroaction complexe formée par le montage en série d'une résistance ohmique ($R_r$) et d'une capacité ($C_r$) .

14. Circuit selon la revendication 10, **caractérisé en ce que** le régulateur est un régulateur PI à amplificateur dépendant de la fréquence, qui est formé par un amplificateur opérationnel avec un montage en série d'une résistance ohmique ($R_r$) et d'une capacité ($C_r$) dont la polarité peut être inversée grâce à un inverseur de polarité (S1, S2), l'inverseur de polarité étant apte à être actionné par le dispositif d'inversion de polarité (RS) pour la tension d'excitation ($\pm U_o$).

**Fig. 1**

**Fig. 1a**

**Fig. 2**

**Fig. 3**

Fig. 4

Fig. 5

Fig. 6

$$\underline{Z}_1 = \underline{Z} - R$$

Fig. 7

Fig. 8

Fig. 9

$$R_a = \frac{R}{1+1/\alpha}$$

Fig. 10

$$R_a = \frac{R}{1-1/\alpha}$$

Fig. 11

15

Fig. 12